# EUROPEAN PATENT SPECIFICATION

(11) **EP 3 716 469 B1**
(45) Date of publication and mention of the grant of the patent: **30.04.2025**
(21) Application number: 17932803.4
(22) Date of filing: 22.11.2017
(51) Int. Cl.: H02P 29/00, H02P 29/02, H02P 29/024, H02P 29/028, H02P 29/032, G01R 31/34, G01R 31/00

(54) **EQUIPMENT DEGRADATION DIAGNOSIS DEVICE**
DIAGNOSEVORRICHTUNG FÜR GERÄTEVERSCHLEISS
DISPOSITIF DE DIAGNOSTIC DE DÉGRADATION D'ÉQUIPEMENT

(43) Date of publication of application: 30.09.2020
(73) Proprietor: Mitsubishi Electric Corporation, Chiyoda-ku Tokyo 100-8310 (JP)
(72) Inventor: MIYAUCHI, Toshihiko, Tokyo 100-8310 (JP)
(74) Representative: Witte, Weller & Partner Patentanwälte mbB
(86) International application number: PCT/JP2017/042019
(87) International publication number: WO 2019/102545

(56) References cited:
- EP-A2- 1 489 475
- WO-A1-2014/156386
- JP-A- 2006 083 928
- JP-A- 2006 083 928
- JP-A- 2008 051 737
- JP-A- 2008 051 737

## Description

### TECHNICAL FIELD

The present invention relates to a facility degradation diagnosis device, for such use as in an enclosed switchboard and a control center, having a navigation function in which, as simple degradation diagnosis on the presence or absence of abnormality in the entirety of an electric power distribution system, the displays of a failure portion and its factor are performed, and a failure treatment method is presented.

### BACKGROUND ART

As for the maintenance and inspection of an electric power distribution system and those of an induction motor (s), a well experienced or skilled maintenance person(s) carries out the inspection on the basis of the five senses over several hundreds to several thousands of electric motors and machine facilities being interspersed in a wide range, depending on the degree of their importance in intervals of every day, every week, every month, and so forth. In such inspection, continuous inspection is required in order to avoid a load halt at the time of abrupt abnormality, and so, much manpower is required.

In addition, an electric motor's diagnosis device is proposed in which, even in an electric motor whose load varies, the presence or absence of abnormality of the electric motor can be diagnosed by means of detecting sideband frequencies appearing in peak states on both sides in vicinity to a power source frequency, or the presence or absence of a winding short-circuit in the electric motor can be diagnosed (for example, refer to Japanese Patent Laid-Open No. 2016-195524, Japanese Patent Publication No. 6113384).

Document EP 1 489 475A2, according to its abstract, states a power meter or overload relay including a housing and a plurality of sensors configured to monitor operation of a motor. Aprocessor is disposed within the housing and is configured to receive operational feedback from the plurality of sensor and proactively determine an operational wellness of the motor from the operational feedback. Document WO 2014/156386 A1, according to its abstract, states that each electric motor has a zero-phase current detector, a phase current detector, and a phase voltage detector attached thereto, and four different types of electric motor abnormalities are detected using only voltage and current analysis. Further, the voltage and current analysis procedure for detecting abnormalities in the four different types of electric motors is set to a prescribed order. Additionally, a monitoring and diagnosis device is provided with a monitoring interval adjustment unit for changing a monitoring interval in accordance with an electric motor abnormality determination level, the length of an operation history, and the level of importance of an electric motor. Document JP 2006 083928 A, according to its abstract, states a method and device for diagnosing irregularity and deterioration of an electric valve device estimating motor torque and rotation speed from only current and voltage applied to an induction motor and performing failure/deterioration diagnosis. The device for diagnosing irregularity and deterioration of the electric valve device is provided with a current sensor, a voltage sensor, a current memory part, a voltage memory part, a memory device, a relative current/voltage conversion part, a three-phase current/three-phase voltage calculation part, an inner product/outer product calculation part, a torque/speed calculation part, an irregularity/speed determination part and a warning signal issue part. Document JP 2008 051737 A, according to its abstract, states that a system comprises a diagnostic device that measures the current harmonics flowing into an electrical facility; a computer to which diagnostic data from the diagnostic device is inputted; and a server with an artificial intelligence engine mounted thereon that is connected to the computer via the Internet, wherein specific correction measures for the electrical facility can be contrived, in response to the degree of abnormal degradation that is occurring in the electrical facility and the level of the degree of the abnormal degradation.

### SUMMARY OF THE INVENTION

### [Problems to be Solved by the Invention]

The solution is defined in independent apparatus claim 1 and the preferred embodiment in dependent claim 2. In a large-scale plant or factory, several hundreds tc several thousands of electric motors are interspersed in a wide range. In addition, in order not to cause a load halt due to an abrupt malfunction, continuous inspection is carried out by a skilled maintenance person(s); however, it is realized that enormous manpower is necessary for the maintenance.

The present invention has been directed at solving those problems described above, and an object of the invention is to provide a facility degradation diagnosis device in which a diagnosis result can be notified to a maintenance person (s) only at the time of abnormality, without carrying out daily inspection according to the inspection on the basis of the five senses by a conventional skilled person(s), but by carrying out simple diagnosis online at all times.

### [Means for Solving the Problems]

There is provided a facility degradation diagnosis device which diagnoses an electric motor and a machine facility that is driven by the electric motor, the facility degradation diagnosis device, comprising: a transmission-data conversion unit for converting a voltage of the electric motor and an electric current thereof, respectively being detected there for, into data suitable for transmission; a facility diagnosis unit for diagnosing, based on said data transmitted by way of a communications line, abnormality of the machine facility, wherein the facility diagnosis unit has a machine facility's abnormality diagnosis unit; wherein the facility diagnosis unit has a machine facility's abnormality diagnosis unit, the machine facility's abnormality diagnosis unit carries out an averaging process on a plurality of analytical results of power spectrums obtained by performing frequency analysis using an electric current waveform when an electric current of the electric motor is stable, detects sideband frequencies from analytical results of power spectrums on which the averaging process has been carried out, and determines the presence or absence of abnormality of a machine facility being a load in accordance with spectrum's peaks in a row; a failure portion/factor estimation unit for estimating a failure region and/or a failure factor thereof based on a result diagnosed by the facility diagnosis unit; a failure treatmentmethod selectionunit for selecting a failure treatment method based on a result obtained by the failure portion/factor estimation unit; and a display unit for displaying a failure region and/or a failure factor thereof obtained by the failure portion/factor estimation unit, and for displaying a failure handling method obtained by the failure treatment method selection unit.

### [Effects of the Invention]

According to the present invention, comprised are a transmission-data conversion unit for converting a voltage of an electric motor and an electric current thereof, respectively being detected therefor, into data suitable for transmission; a facility diagnosis unit for diagnosing, based on the data transmitted by way of a communications line, abnormality of the electric motor and/or that of a machine facility; a failure portion/factor estimation unit for estimating a portion of a failure and/or a factor thereof based on a result diagnosed by the facilitydiagnosis unit; a failure treatmentmethod selection unit for selecting a failure treatment method based on a result obtained by the failure portion/factor estimation unit; and a display unit for displaying a portion of a failure and/or factor thereof obtained by the failure portion/factor estimation unit, and for displaying a failure handling method obtained by the failure treatment method selection unit, so that, without carrying out daily inspection according to the inspection on the basis of the five senses by a conventional skilled person (s), simple diagnosis is carried out online at all times, whereby a diagnosis result can be notified to a maintenance person(s) only at the time of abnormality. In addition, because a failure portion and its factor are identified in the diagnosis content, and further a handling or treatment-directionmethod is presented to navigate according to the content, it is made possible to suitably and quickly carry out precise inspection, so that a plant halt time can be reduced, and an inspection time by the maintenance person(s) can be significantly reduced.

### BRIEF DESCRIPTION OF DRAWINGS

FIG. 1 is a schematic configuration diagram illustrating an installation situation of a facility degradation diagnosis device according to Embodiment 1 of the present invention;
FIG. 2 is a block diagram illustrating a configuration of a logic calculation unit of the facility degradation diagnosis device according to Embodiment 1 of the present invention;
FIG. 3 is a flow chart for explaining the operations of the facility degradation diagnosis device according to Embodiment 1 of the present invention;
FIG. 4 is a diagram illustrating a display example of a failure portion and/or its factor at the time of a failure being occurred in regard to the facility degradation diagnosis device according to Embodiment 1 of the present invention;
FIG. 5 is a diagram illustrating a display example of a failure portion and/or its factor in an electric motor at the time of the failure thereof being occurred in regard to the facility degradation diagnosis device according to Embodiment 1 of the present invention;
FIG. 6 is a diagram illustrating a display example of a failure treatment method in the facility degradation diagnosis device according to Embodiment 1 of the present invention; and
FIG. 7 is a configuration diagram illustrating a facility degradation diagnosis device according to Embodiment 2 of the present invention.

### EMBODIMENTS FOR CARRYING OUT THE INVENTION

Hereinafter, the explanation will be made referring to the drawings for the embodiments according to the present invention. Note that, in each of the figures, the same reference numerals and symbols designate the same items as, or the items corresponding to, those shown in the drawings.

### Embodiment 1.

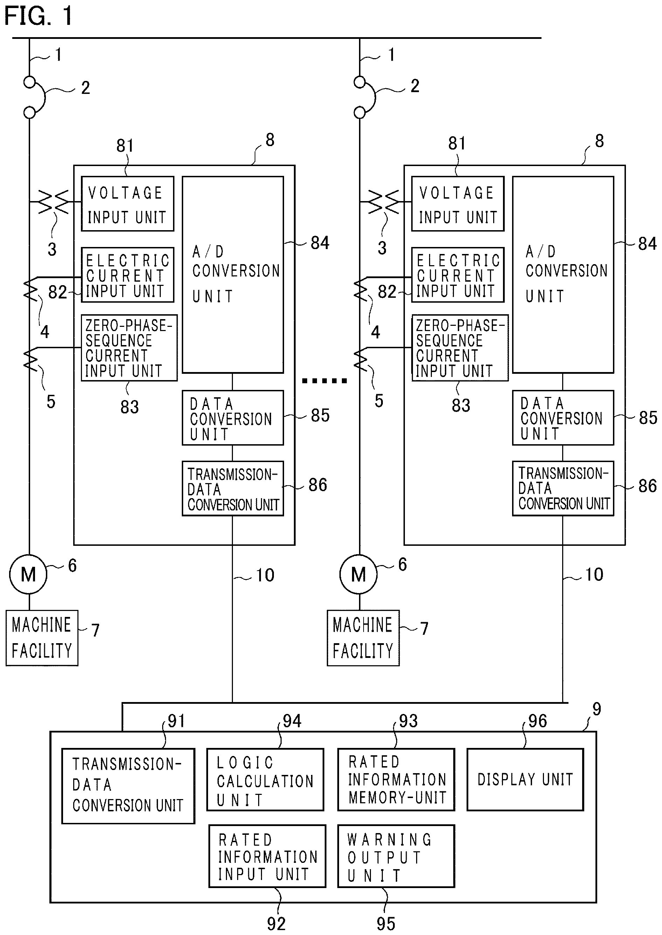

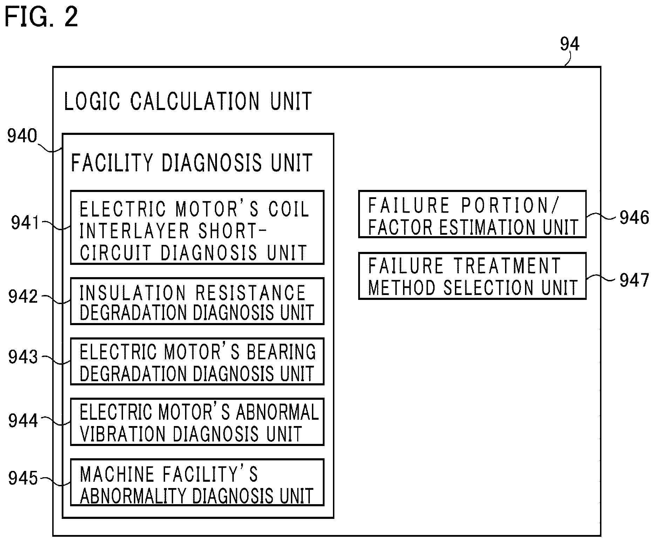

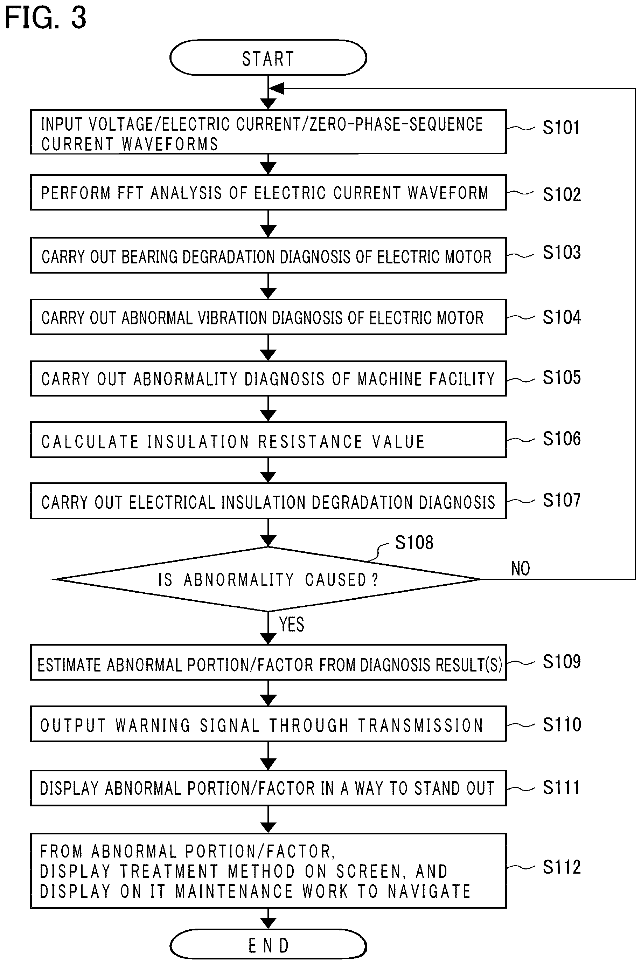

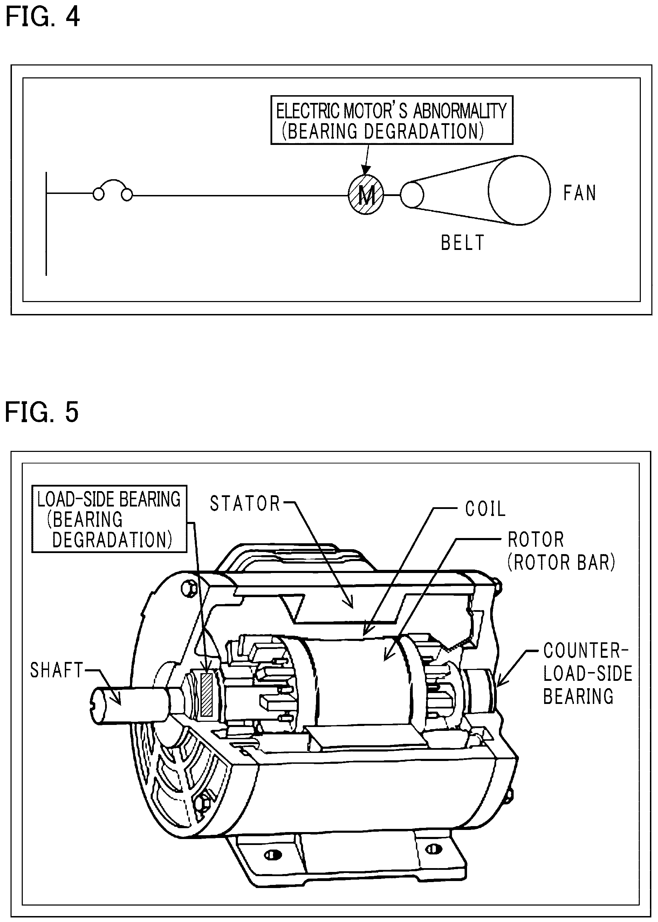

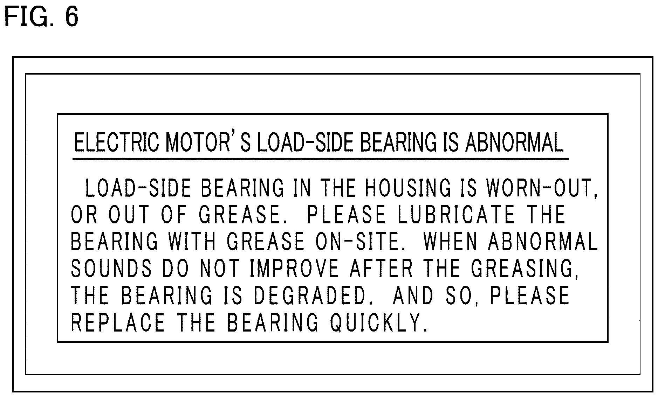

FIG. 1 is a schematic configuration diagram illustrating an installation situation of a facility degradation diagnosis device according to Embodiment 1 of the present invention; FIG. 2 is a block diagram illustrating a configuration of a logic calculation unit of the facility degradation diagnosis device according to Embodiment 1; FIG. 3 is a flow chart for explaining the operations of the facility degradation diagnosis device according to Embodiment 1; FIG. 4 is a diagram illustrating a display example of a failure portion and/or its factor at the time of a failure being occurred in regard to the facility degradation diagnosis device according to Embodiment 1;FIG. 5 is a diagram illustrating a display example of a failure portion and/or its factor in an electric motor at the time of the failure thereof being occurred in regard to the facility degradation diagnosis device according to Embodiment 1; and FIG. 6 is a diagram illustrating a display example of a failure treatment method in the facility degradation diagnosis device according to Embodiment 1.

In FIG. 1, for a main circuit 1 which is led in from an electric power system, provided are a molded-case circuit-breaker 2, a voltage detector 3, an electric current detector 4 such as an instrument transformer for detecting three-phase load currents, and a zero-phase-sequence current detector 5 for detecting zero-phase-sequence currents. To the main circuit 1, an electric motor 6 is connected which is a load such as a three-phase induction motor or the like, and a machine facility (a fan, a pump, a compressor, and/or the like) 7 is operationally driven by means of the electric motor 6. The facility degradation diagnosis device is constituted of digital conversion devices 8 and a data calculation device 9.

The digital conversion devices 8 each include a voltage input unit 81 for inputting a voltage having been detected by the voltage detector 3, an electric current input unit 82 for inputting an electric current having been detected by the electric current detector 4, and a zero-phase-sequence current input unit 83 for inputting a zero-phase-sequence current having been detected by the zero-phase-sequence current detector 5. Signals having been converted into predetermined signal levels by the voltage input unit 81, the electric current input unit 82 and the zero-phase-sequence current input unit 83 are converted by means of an A/D conversion unit 84 in an analog-to-digital form, which is digitally processed into digital data of a predetermined form(s) by means of a data conversion unit 85. In addition, digital data required for the degradation diagnosis device is converted into transmission data by means of a transmission-data conversion unit 86.

The transmission data having been produced by the digital conversion devices 8 each is transmitted into the data calculation device 9 by way of communications lines 10.

For the data calculation device 9, provided are a rated information input unit 92 into which inputted in advance are a power source frequency, a rated output of the electric motor 6, a rated voltage thereof, a rated electric current thereof, the number of poles thereof, the number of rated revolutions thereof and the like, and also a connection method between a machine facility and the electric motor (abelt, agear, acoupling or the like) and wiring conditions (an electrical wiring line length, a wiring line diameter, electrostatic capacitance, and the like); and a rated information memory-unit 93 for storing the information inputted from the rated information input unit 92. Rated information of the electric motor 6 is information which can be easily acquired by having a look at a manufacturing company' s catalog of the electric motor 6, or at its plate attached on the electric motor 6. Note that, when there exists a plurality of such electric motors 6 as diagnosis targets under consideration, rated information of the electric motors 6 as all of the diagnosis targets under consideration is inputted in advance; however, in the following description, the explanation will be made for the single electric motor 6.

In the degradation diagnosis device, transmission data from the communications lines 10 each is treated by processing the data into a digital value(s) by using a transmission-data conversion unit 91.

For the degradation diagnosis device, provided are the logic calculation unit 94 for diagnosing the presence or absence of abnormality of the electric motor 6 and/or a machine facility 7, and a warning output unit 95 for outputting a warning by means of an alert, lighting of an abnormality lamp or the like, when abnormality is discovered by the logic calculation unit 94.

The logic calculation unit 94 is constituted of a facility diagnosis unit 940, and a failure portion/ factor estimation unit 946 and a failure treatment method selection unit 947.

The facility diagnosis unit 940 has an electric motor's coil interlayer short-circuit diagnosis unit 941, an insulation resistance degradation diagnosis unit 942, an electric motor's bearing degradation diagnosis unit 943, an electric motor's abnormal vibration diagnosis unit 944, and a machine facility's abnormality diagnosis unit 945.

The electric motor's coil interlayer short-circuit diagnosis unit 941 distinguishes power-source unbalance from a negative-phase-sequence current, a negative-phase-sequence voltage, a positive-phase-sequence current and a negative-phase-sequence admittance by means of voltage-current analysis of an electric motor even when the electric motor is in operation and its load torque varies, and detects a winding short-circuit (interlayer short-circuit) by determining as it is.

The insulation resistance degradation diagnosis unit 942 measures at all times insulation resistance of a load circuit or the like so that the control is made possible based on a measurement result, and keeps track of an insulation degradation situation without stopping the load circuit.

The electric motor's bearing degradation diagnosis unit 943 performs FFT analysis on a power spectrum of an electric current of an electric motor when the electric current thereof is in a stable state, smooths a plurality of charges of power spectrums each having been analyzed, and extracts sideband frequencies of a power spectrum having been smoothed, whereby degradation of an electric motor's bearing is diagnosed as it is when a sideband frequency is extracted whose signal intensity is a preset value or more.

The electric motor's abnormal vibration diagnosis unit 944 determines the presence or absence of abnormality of an electric motor by carrying out an averaging or smoothing process on a plurality of charges of analytical results of power spectrums obtained by performing frequency analysis using an electric current waveform when an electric current of the electric motor is stable, by detecting sideband frequencies from analytical results of power spectrums on which the smoothing process has been carried out, and also by calculating a difference value between a power spectrum's peak of a power source frequency of the electric motor and a power spectrum's peak in a rotational frequency band thereof.

The machine facility's abnormality diagnosis unit 945 carries out an averaging or smoothing process on a plurality of charges of analytical results of power spectrums obtained by performing frequency analysis using an electric current waveform when an electric current of the electric motor is stable, detects sideband frequencies from analytical results of power spectrums on which the smoothing process has been carried out, and determines the presence or absence of abnormality of a machine facility being a load in accordance with spectrum's peaks in a row.

According to these failure diagnosis results, the estimation of a failure portion and that of its factor are performed in the failure portion/factor estimation unit 946.

In addition, a failure portion is displayed in a way that stands out on a display unit 96 as shown in FIG. 4, whether a failure is caused at what portion in a power distribution system with what kind of the failure.

Moreover, as for the electric motor, a detailed failure portion inside the electric motor is estimated, and the failure portion and a failure factor are displayed in a way that stands out on the display unit 96 as shown in FIG. 5.

With respect to the failure portion and the failure factor, the selection is made how an on-site maintenance person is to handle according to the failure treatment method selection unit 947, and a handling or treatment method is displayed on the display unit 96 as shown in FIG. 6.

In accordance with this arrangement, it is made possible to quickly correspond to appropriate handling or treatment.

Next, the explanation will be made referring to FIG. 3 for the operations. FIG. 3 is a flow chart for explaining the operations of the facility degradation diagnosis device according to Embodiment 1. The facility degradation diagnosis device is started up in predetermined time spacings, and the device executes the following processes.

At Step S101, a voltage(s) of the electric motor 6 and electric currents thereof having been detected by the voltage detector 3, the electric current detector 4 and the zero-phase-sequence current detector 5 are inputted into the voltage input unit 81, the electric current input unit 82 and the zero-phase-sequence current input unit.

At Step S102, FFT analysis is performed by using an electric current waveform in an interval in which electric current values having been inputted are in a stable state, and frequency analysis is performed between the frequencies from 0 Hz to a two-fold frequency, 120 Hz, of a power source frequency 60Hz, whereby an analytical result of power spectrum is obtained.

At Step S103, the electric motor's bearing degradation diagnosis unit 943 carries out bearing degradation diagnosis of the electric motor 6.

At Step S104, the electric motor's abnormal vibration diagnosis unit 944 carries out abnormal vibration diagnosis of the electric motor 6.

At Step S105, the machine facility' s abnormality diagnosis unit 945 carries out abnormality diagnosis of the machine facility 7.

At Step S106, the insulation resistance degradation diagnosis unit 942 carries out insulation resistance degradation diagnosis of the electric motor 6.

At Step S107, the electric motor's coil interlayer short-circuit diagnosis unit 941 carries out electrical insulation degradation diagnosis of the electric motor 6.

At Step S108, based on the results of Step S101 through Step S107, determination is performed whether abnormality is caused in the facility or not.

When determination is performed at Step S108 so that there exists no abnormality (NO), the processing returns to Step S101, and the aforementioned Steps are repeated.

When determination is performed at Step S108 so that there exists abnormality (YES), the processing proceeds to Step S109.

At Step S109, the failure portion/factor estimation unit 946 estimates a portion of a failure and/or a factor thereof.

At Step S110, a warning is outputted from the warning output unit 95.

At Step S111, based on an estimation result of a portion of abnormality and/or a factor thereof in the failure portion/factor estimation unit 946, the displays of FIG. 4 and FIG. 5 are performed on the display unit 96.

At Step S112, the display shown in FIG. 6 is performed on the display unit 96.

As explained above, because a failure portion of an electric power system and a failure factor thereof are displayed at the time of a failure being occurred, and because a failure handling or treatment method is displayed and the correspondence at the time of the failure is presented to navigate, an effect can be achieved as obtaining that the appropriate handling or treatment can be carried out quickly, and it is made possible to enhance operational efficiency of a plant and to significantly reduce its maintenance time.

In addition, because transmission data is transmitted into a data calculation device by way of a communications line(s), the data calculation device can accept its inputs from a plurality of electric-current digital conversion devices, so that abnormality of a plurality of electric motors can be diagnosed by means of the one data calculation device.

### Embodiment 2.

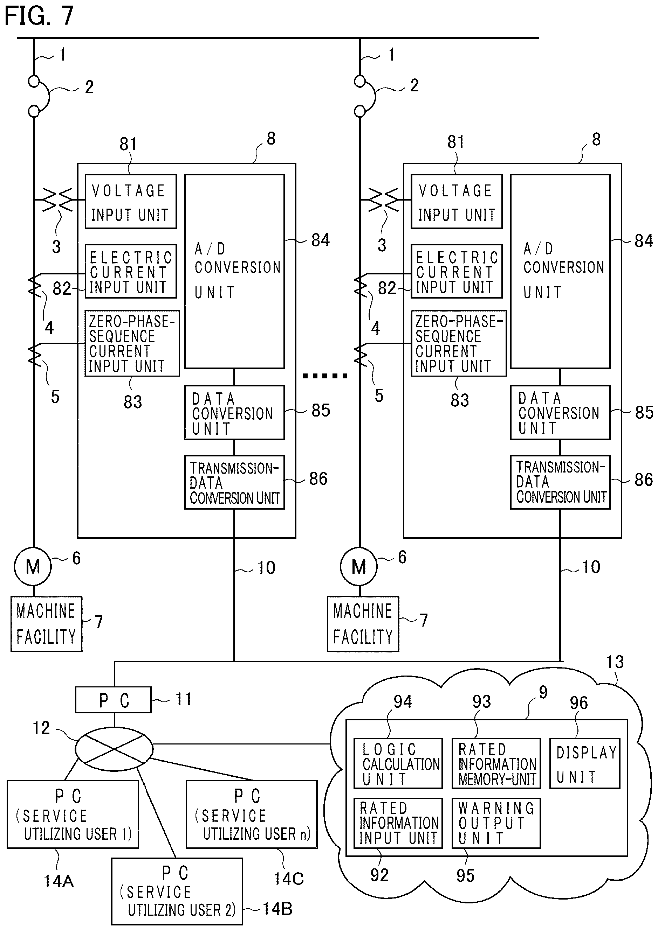

FIG. 7 is a configuration diagram of a facility degradation diagnosis device according to Embodiment 2 of the present invention. The facility degradation diagnosis device according to Embodiment 2 is the same in its basic configuration as the degradation diagnosis device according to Embodiment 1; however, as shown in FIG. 7, data having been digitized into a form similar to that of Embodiment 1 is inputted from the digital conversion devices 8 into a personal computer (hereinafter, referred to as a "PC") 11 by way of the communications lines 10.

The PC 11 is interconnected to an Internet network 12, whereby software of an electric motor's diagnosis tool being a degradation diagnosis tool is operated at all times on a cloud (cloud computing) 13 which is dedicated as the data calculation device 9, so that the data is supplied by way of the Internet network 12 into the degradation diagnosis tool on the cloud, and electric motor diagnosis functions operate on the cloud. To the Internet network 12, PCs 14A, 14B and 14C are interconnected, which are users utilizing the service of electric motor diagnosis. Display data on the display unit 96 is shown on display units of the PCs 14A, 14B and 14C each.

As for the degradation diagnosis functions, they are similar to those in Embodiment 1.

As for advantageous effects to operate on a cloud, a PC's operating system (OS) is not dependent thereon, and an upgrade of software of the diagnosis tool is performed on the cloud, and thus, it becomes possible to offer an upgrade service without altering anything on a user's PC(s).

As for electric current data which is digitized into a form, it is possible to offer a service thereof in either case of storing the data on the cloud, or case of storing it on a PC (s) .

In addition, it becomes possible for a plurality of users utilizing the service to receive the service offer by making access to the software on the cloud.

### [Explanation of Numerals and Symbols]

Numeral "1" designates a main circuit; "2," molded-case circuit-breaker; "3," voltage detector; "4," electric current detector; "5," zero-phase-sequence current detector; "6," electric motor; "7," machine facility; "8," digital conversion device; "9, " data calculation device; "94, " logic calculation unit; "96," display unit; "940, " facility diagnosis unit; "941, " electric motor's coil interlayer short-circuit diagnosis unit; "942, " insulation resistance degradation diagnosis unit; "943, " electric motor's bearing degradation diagnosis unit; "944," electric motor's abnormal vibration diagnosis unit; "945," machine facility' s abnormality diagnosis unit; "946, " failure portion/factor estimation unit; and "947," failure treatment method selection unit.

## Claims

1. A facility degradation diagnosis device which diagnoses an electric motor (6) and a machine facility (7) that is driven by the electric motor (6), the facility degradation diagnosis device, comprising:
a transmission-data conversion unit (86) for converting a voltage of the electric motor (6) and an electric current thereof, respectively being detected therefor, into data suitable for transmission;
a facility diagnosis unit (940) for diagnosing, based on said data transmitted by way of a communications line (10), abnormality of the machine facility (7), wherein the facility diagnosis unit has a machine facility's abnormality diagnosis unit (945), the machine facility's abnormality diagnosis unit (945) carries out an averaging process on a plurality of analytical results of power spectrums obtained by performing frequency analysis using an electric current waveform when an electric current of the electric motor is stable, detects sideband frequencies from analytical results of power spectrums on which the averaging process has been carried out, and determines the presence or absence of abnormality of a machine facility being a load in accordance with spectrum's peaks in a row;
a failure portion/factor estimation unit (946) for estimating a failure region and/or a failure factor thereof based on a result diagnosed by the facility diagnosis unit (940);
a failure treatment method selection unit (947) for selecting a failure treatment method based on a result obtained by the failure portion/factor estimation unit (946); and
a display unit (96) for displaying a failure region and/or a failure factor thereof obtained by the failure portion/factor estimation unit (946), and for displaying a failure handling method obtained by the failure treatment method selection unit (947).

2. The facility degradation diagnosis device as set forth in claim 1, wherein said data obtained by the transmission-data conversion unit (86) is supplied by way of an internet network (12) into a degradation diagnosis tool on a cloud (13).

## Patentansprüche

1. Einrichtung zur Diagnostizierung eines Anlagenverschleißes, die einen Elektromotor (6) und eine von dem Elektromotor (6) angetriebene Maschinenanlage (7) diagnostiziert, wobei die Einrichtung zur Diagnostizierung eines Anlagenverschleißes aufweist:
eine Übertragungsdaten-Umwandlungseinheit (86) zum Umwandeln einer Spannung des Elektromotors (6) und eines elektrischen Stroms desselben, die jeweils dafür detektiert werden, in Daten, die für die Übertragung geeignet sind;
eine Anlagendiagnoseeinheit (940) zur Diagnose, basierend auf den Daten, die über eine Kommunikationsleitung (10) übertragen werden, einer Abnormalität der Maschinenanlage (7), wobei die Anlagendiagnoseeinheit eine Abnormalitätsdiagnoseeinheit (945) für die Maschinenanlage aufweist, wobei die Abnormalitätsdiagnoseeinheit (945) für die Maschinenanlage einen Mittelwertbildungsprozess an einer Vielzahl von Analyseergebnissen von Leistungsspektren durchführt, die durch Frequenzanalyse unter Verwendung einer elektrischen Stromwellenform erhalten wurden, wenn ein elektrischer Strom des Elektromotors stabil ist, Nebenbandfrequenzen aus Analyseergebnissen von Leistungsspektren detektiert, an denen der Mittelwertbildungsprozess durchgeführt wurde, und das Vorhandensein oder Nichtvorhandensein einer Abnormalität einer Maschinenanlage als Last gemäß Spektrumsspitzen in einer Reihe bestimmt;
eine Ausfalleinheit/Ausfallfaktor-Schätzungseinheit (946) zum Schätzen eines Ausfallbereichs und/oder eines Ausfallfaktors desselben basierend auf einem durch die Anlagendiagnoseeinheit (940) diagnostizierten Ergebnis;
eine Ausfallbehandlungsverfahren-Auswahleinheit (947) zum Auswählen eines Ausfallbehandlungsverfahrens basierend auf einem durch die Ausfalleinheit/Ausfallfaktor-Schätzungseinheit (946) erhaltenen Ergebnis; und
eine Anzeigeeinheit (96) zum Anzeigen eines durch die Ausfalleinheit/Ausfallfaktor-Schätzungseinheit (946) erhaltenen Ausfallbereichs und/oderAusfallfaktors davon sowie zum Anzeigen eines durch die Ausfallbehandlungsverfahren-Auswahleinheit (947) erhaltenen Ausfallbehandlungsverfahrens.

2. Einrichtung zur Diagnostizierung eines Anlagenverschleißes nach Anspruch 1, wobei die durch die Übertragungsdaten-Umwandlungseinheit (86) erhaltenen Daten über ein Internetnetzwerk (12) in ein Verschleißdiagnosewerkzeug in einer Cloud (13) eingespeist werden.

## Revendications

1. Dispositif de diagnostic de dégradation d'une installation qui diagnostique un moteur électrique (6) et une installation de machine (7) entraînée par le moteur électrique (6), le dispositif de diagnostic de dégradation de l'installation, comprenant :
une unité de conversion transmission-données (86) pour convertir une tension du moteur électrique (6) et un courant électrique de celui-ci, respectivement détecté à cet effet, en données adaptées à la transmission ;
une unité de diagnostic d'installation (940) pour diagnostiquer, sur la base desdites données transmises au moyen d'une ligne de communication (10), une anomalie de l'installation de machine (7), dans lequel l'unité de diagnostic d'installation ayant une unité de diagnostic d'anomalie d'installation de machine (945), l'unité de diagnostic d'anomalie d'installation de machine (945) effectue un processus de moyennage sur une pluralité de résultats analytiques de spectres de puissance obtenus en effectuant une analyse de fréquence à l'aide d'une forme d'onde de courant électrique lorsqu'un courant électrique du moteur électrique est stable, détecte les fréquences de bande latérale à partir de résultats analytiques de spectres de puissance sur lesquels le processus de moyennage a été effectué, et détermine la présence ou l'absence d'anomalie d'une installation de machine constituant une charge en fonction des pics de spectre dans une rangée ;
une unité d'estimation de partie/facteur de défaillance (946) pour estimer une zone de défaillance et/ou un facteur de défaillance de celle-ci sur la base d'un résultat diagnostiqué par l'unité de diagnostic d'installation (940) ;
une unité de sélection de procédé de traitement de défaillance (947) pour sélectionner un procédé de traitement de défaillance sur la base d'un résultat obtenu par l'unité d'estimation de partie/facteur de défaillance (946) ; et
une unité d'affichage (96) pour afficher une zone de défaillance et/ou un facteur de défaillance de celle-ci obtenu par l'unité d'estimation de la partie/facteur de défaillance (946), et pour afficher un procédé de traitement de défaillance obtenu par l'unité de sélection du procédé de traitement de la défaillance (947).

2. Dispositif de diagnostic de dégradation d'installation selon la revendication 1, dans lequel lesdites données obtenues par l'unité de conversion transmission-données (86) sont fournies au moyen d'un réseau Internet (12) à un outil de diagnostic de dégradation sur un nuage (13).
